# EUROPÄISCHE PATENTSCHRIFT

(11) **EP 3 679 383 B1**
(45) Veröffentlichungstag und Bekanntmachung des Hinweises auf die Patenterteilung: **19.04.2023**
(21) Anmeldenummer: 18765596.4
(22) Anmeldetag: 31.08.2018
(51) Int. Cl.: H02M 3/156, H02M 3/158, G01R 31/36, G01R 31/367

(54) **ENERGIESPEICHEREMULATOR UND VERFAHREN ZUR EMULATION EINES ENERGIESPEICHERS**
ENERGY ACCUMULATOR EMULATOR AND METHOD FOR EMULATION OF AN ENERGY ACCUMULATOR
ÉMULATEUR D'ACCUMULATEUR D'ÉNERGIE ET PROCÉDÉ POUR ÉMULER UNE ACCUMULATEUR D'ÉNERGIE

(30) Priorität: 04.09.2017 AT 507422017
(43) Veröffentlichungstag der Anmeldung: 15.07.2020
(73) Patentinhaber: AVL List GmbH, 8020 Graz (AT)
(72) Erfinder: KÖNIG, Oliver, 8042 Graz (AT); FALMBIGL, Wolfgang, 1030 Wien (AT); JAKUBEK, Stefan, 1230 Wien (AT); EDER, Alexander, 8063 Hof-Präbach (AT); PROCHART, Günter, 8042 Graz (AT)
(74) Vertreter: Patentanwälte Pinter & Weiss OG
(86) Internationale Anmeldenummer: PCT/EP2018/073422
(87) Internationale Veröffentlichungsnummer: WO 2019/043136

(56) Entgegenhaltungen:
- EP-A1- 2 863 528
- WO-A1-2015/154918
- KÖNIG OLIVER ET AL: "Model predictive control of a DC-DC converter for battery emula", CONTROL ENGINEERING PRACTICE, PERGAMON PRESS, OXFORD, GB, Bd. 21, Nr. 4, 31. Januar 2013 (2013-01-31), Seiten 428-440, XP028980413, ISSN: 0967-0661, DOI: 10.1016/J.CONENGPRAC.2012.12.009
- PEJCIC IVAN ET AL: "Voltage source converter MPC with optimized pulse patterns and minimization of integrated squared tracking error", 2017 AMERICAN CONTROL CONFERENCE (ACC), AACC, 24 May 2017 (2017-05-24), pages 4069-4074, XP033110565, DOI: 10.23919/ACC.2017.7963579 [retrieved on 2017-06-29]

## Beschreibung

Die gegenständliche Erfindung betrifft einen Energiespeicheremulator bestehend aus einem eine Anzahl Leistungsschalter umfassenden DC/DC-Wandler, der eine Ausgangsspannung und einem ausgangsseitigen Laststrom zur Verfügung stellt, einer Steuerungseinheit, die ausgestaltet ist aus elektrischen Größen des DC-DC/Wandlers einen Referenzstrom zu berechnen und einem Batteriemodell, das mit der Steuerungseinheit verbunden ist und ausgestaltet ist den Referenzstrom zu beziehen, zu verarbeiten und daraus eine Referenzspannung zu berechnen und der Steuerungseinheit zur Verfügung zu stellen, wobei in der Steuerungseinheit ein Spannungsregler vorgesehen ist, der die Referenzspannung verarbeitet und einen einzustellenden Strom regelt, auf dessen Basis die Steuerungseinheit die über Schaltpulse ansteuert um die Ausgangspannung zu regeln. Weiters betrifft die gegenständliche Erfindung ein Verfahren zur Emulation eines Energiespeichers, wobei eine Ausgangsspannung eines DC/DC-Wandlers geregelt wird, indem eine Steuerungseinheit aus elektrischen Größen des DC-DC/Wandlers einen Referenzstrom berechnet und an ein Batteriemodell liefert, wobei das Batteriemodell den Referenzstrom verarbeitet, daraus die Referenzspannung berechnet und an den Spannungsregler übergibt, welcher die Referenzspannung verarbeitet und einen einzustellenden Strom regelt, auf dessen Basis die Steuerungseinheit die Leistungsschalter mittels Schaltpulsen ansteuert, um die Ausgangspannung zu regeln.

In der Entwicklung von elektrischen Energiespeichern, insbesondere von Traktionsbatterien oder Batteriepacks für Hybrid- oder Elektrofahrzeuge, spielen Energiespeicheremulatoren, die das reale Verhalten eines Energiespeichers nachbilden, eine große Rolle. Solche Energiespeicher sind sehr teuer, weshalb es vorteilhaft ist, den Energiespeicher zu emulieren und die Entwicklungsarbeit bzw. Tests an der Emulation durchzuführen. Abgesehen davon, kann es in frühen Entwicklungsstadien auf sein, dass der Energiespeicher noch gar nicht vorliegt, weshalb auch auf eine Emulation zurückzugreifen ist. Ein Energiespeicheremulator umfasst dabei ein Energiespeichermodell, das aus einer Leistungsanforderung, z.B. einem gewünschten Strom, die Ausgangsspannung berechnet und diese am Ausgang des Energiespeicheremulators einstellt, die sich dabei bei der realen Batterie einstellen würde. Je nach Komplexität und Art des Energiespeichermodells können verschiedene Einflussgrößen berücksichtigt werden, wie z.B. Last, Temperatur, Ladezustand (SoC - State of Charge), Batteriechemie, etc.

Ein solcher Energiespeicheremulator geht z.B. aus der AT 510 998 A2 und der AT 513 676 A2 hervor. Ein Energiespeicheremulator erzeugt in der Regel eine Ausgangsspannung in Abhängigkeit von einem Laststrom. Dazu wird der Laststrom gemessen, über eine Steuereinheit in einen Referenzstrom gewandelt und einem Batteriemodell zugeführt. Das Batteriemodell berechnet aus dem Referenzstrom eine Referenzspannung. Die Steuereinheit regelt die Ausgangsspannung nach dieser Referenzspannung, die an eine elektrische Last geliefert wird.

Im Energiespeicheremulator ist dazu typischerweise Leistungselektronik in Form eines DC/DC-Wandlers implementiert, der die benötige Ausgangsspannung, bzw. den benötigten Laststrom zur Verfügung stellt. Die Schalter des DC/DC-Wandlers werden durch die Steuereinheit angesteuert, um die gewünschte Ausgangsspannung bzw. den gewünschten Laststrom einzustellen. In der Steuereinheit ist in der Regel eine hinlänglich bekannte Pulsweitenmodulation (PWM) vorgesehen, um über das Tastverhältnis (duty cycle) der Schalter die Ausgangsspannung einzustellen. Bei einer PWM werden die Schalter in jedem Abtastzeitpunkt, gegeben durch eine bestimmte Abtastrate, einmal geschaltet. Die maximale Abtastrate ist damit abhängig von der zulässigen Häufigkeit, mit der die Schalter, in der Regel Bipolartransistoren mit isolierter Gate-Elektrode (IGBT) oder Metall-Oxid-Halbleiter-Feldeffekttransistoren (MOSFET), geschaltet werden können. Die Häufigkeit mit der die Schalter geschalten werden können ist jedoch auch durch die beim Schalten entstehenden Schaltverluste begrenzt. Da die PWM bei jedem Abtastschritt schaltet, begrenzt diese Limitierung auch die Abtastrate und somit auch die Reglerbandbreite. Diese Beschränkung führt zu einer schlechten Dynamik der Regelung solcher Wandler, dahingehend, dass oftmals nicht schnell genug auf Störungen oder transiente Schaltvorgänge der Last, was transienten Spannungssprünge erfordert, reagiert werden kann. Eine Erhöhung der Abtastrate in Form einer Überabtastung ist zwar möglich, aber nur unter starken Einschränkungen, weshalb Überabtastung für die Regelung des DC/DC-Wandlers keine praktische Relevanz hat.

Um diesen Nachteil einer PWM zu umgehen ist eine ein sogenannte Finite Control Set Model Predictive Control (FCS-MPC) als Regelstrategie bekannt. Bei dieser Regelstrategie werden die Schalter direkt angesteuert, weshalb auf eine PWM verzichtet werden kann. Damit kann auch die Abtastrate erhöht und die Dynamik der Regelung verbessert werden. Solche Verfahren zur Direktansteuerung der Schalter in leistungselektronischen Systemen sind nicht neu. Ein Überblick darüber kann z.B. in J. Rodriguez, et al., "State of the art of finite control set model predictive control in power electronics", Industrial Informatics, IEEE Transactions, 9(2):1003 - 1016, Mai 2013 gefunden werden. In der EP 2 528 225 B1 findet diese Regelstrategie z.B. Anwendung für die Regelung einer elektrischen Maschine. FCS-MPC zeichnet sich durch die beschränkte Anzahl Möglichkeiten für die Stellgröße, das sogenannte finite control set, aus.

In der WO 2013/174967 A1 ist ein modellprädiktives Regelverfahren für einen Batterieemulator beschrieben und in der WO 2013/174972 A1 ein modellprädiktives Regelverfahren für einen Batterietester. Darin wird allgemein das Verfahren der modellprädiktiven Regelung erläutert und ein Verfahren angegeben, mit dem das Optimierungsproblem ausreichend schnell gelöst werden kann, um Abtastraten im kHz Bereich zu ermöglichen. Die Ansteuerung des DC/DC-Wandlers erfolgt hier aber wieder jeweils mittels einer PWM mit allen oben erläuterten Nachteilen, insbesondere der Begrenzung der Abtastrate.

Die AT 513 776 B1 offenbart ein Verfahren zur modellprädiktiven Regelung eines DC/DC-Wandlers, mit dem das Optimierungsproblem auch bei großen Prädiktionshorizonten ausreichend schnell gelöst werden kann. Dazu wird das Optimierungsproblem der modellprädiktiven Regelung in zwei Optimierungsprobleme aufgeteilt wird, indem in der Steuereinheit ein modellprädiktiver Ausgangsgrößenregler und ein modellprädiktiver Drosselstromregler implementiert werden, wobei für den Ausgangsgrößenregler die Stränge des mehrphasigen DC/DC-Wandlers zu einem einzigen Strang zusammengefasst werden und daraus ein zeitdiskretes Zustandsraummodell erstellt wird und der Ausgangsgrößenregler anhand einer ersten Kostenfunktion des Optimierungsproblems des Ausgangsgrößenreglers die Eingangsspannung des nächsten Abtastschrittes für diesen einzigen Strang prädiziert, die dem Drosselstromregler als Vorgabe vorgegeben wird und der Drosselstromregler daraus anhand einer zweiten Kostenfunktion des Optimierungsproblems des Drosselstromreglers für den nächsten Abtastschritt die notwendigen Schalterstellungen der Schalter der Stränge des mehrphasigen DC/DC-Wandlers ermittelt. Durch die Aufteilung des Reglers in zwei modellprädiktive, kaskadierte Unterregler, wird die Ordnung des Zustandsraummodells reduziert, womit auch das finite control set der modellprädiktiven Regelung reduziert wird. Lösungen des Optimierungsproblems können daher mit dem erfindungsgemäßen Ansatz rascher gefunden werden, was es ermöglicht, auch größere Prädiktionshorizonte mit hohen Abtastraten zu verwenden. Jedoch ist auch in diesem Verfahren eine Abhängigkeit von einer Taktfrequenz gegeben, womit die Dynamik der Regelung eingeschränkt ist.

Es ist somit eine Aufgabe der gegenständlichen Erfindung einen Energiespeicheremulator anzugeben, welcher bei der Regelung der Ausgangsspannung eine größere Dynamik und Flexibilität aufweist.

Diese Aufgabe wird erfindungsgemäß durch eine im Energiespeicheremulator gemäß Anspruch 1 gelöst.

Weiters wird die Aufgabe durch ein Verfahren zum Regeln einer Ausgangsspannung eines DC/DC-Wandlers eines Energiespeicheremulators gemäß Anspruch 2 gelöst.

Die gegenständliche Erfindung wird nachfolgend unter Bezugnahme auf die Figuren 1 bis 3b näher erläutert, die beispielhaft, schematisch und nicht einschränkend vorteilhafte Ausgestaltungen der Erfindung zeigen. Dabei zeigt
Fig.1 einen Energiespeicheremulator
Fig.2 eine PCCC-Einheit
Fig.3a eine Auswahl an Pulsmustern
Fig.3b daraus abgeschätzte Werte der Strangströme.

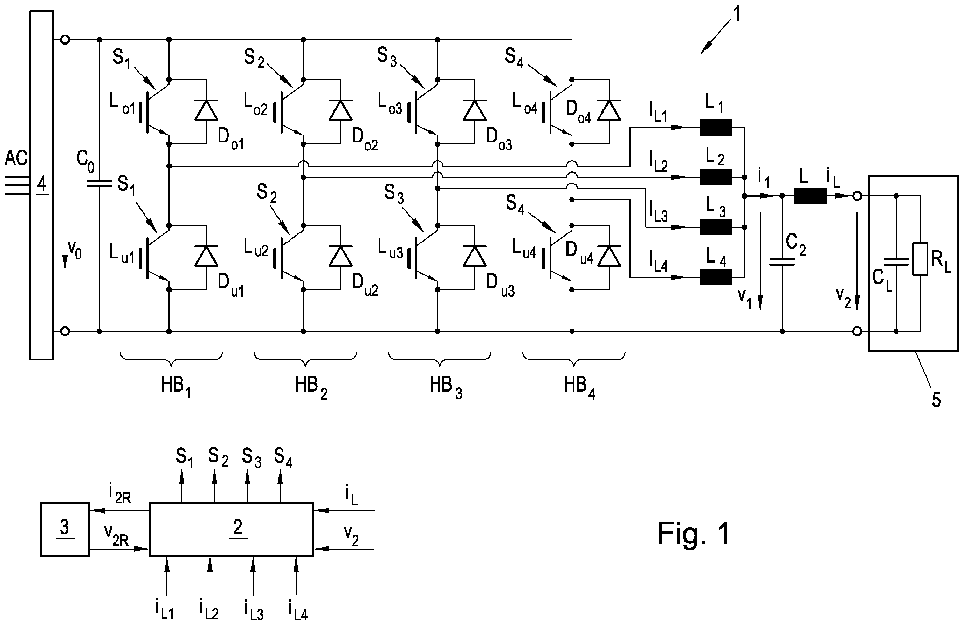

Fig. 1 offenbart eine mögliche Ausgestaltung eines Energiespeicheremulators, der einer elektrischen Last 5, beispielsweise ein (teil)elektrischer Antriebsstrang eines Fahrzeugs, eine Ausgangsspannung v₂ bzw. einen Laststrom i_{L} zur Verfügung stellt. Die elektrische Last 5 wird hier beispielhaft aus einer Lastkapazität C_{L} und einem Lastwiderstand R_{L} modelliert. Dazu wird beispielsweise der Laststrom i_{L} und die Ausgangsspannung v₂ ermittelt, einer Steuereinheit 2 zugeführt, welche aus dem Laststrom i_{L} wiederum einen Referenzstrom i_{2R} für ein Batteriemodell 3 berechnet und diesen dem Batteriemodell 3 zugeführt. Diese Umrechnung ist natürlich abhängig von der Art des Batteriemodells 3. Das Batteriemodell 3 berechnet aus dem Laststrom i_{L} eine Referenzspannung v_{2R}, und liefert diese an die Steuereinheit 2, welche darauf basierend über binärer Schaltpulse S₁, S₂, S₃, S₄ Leistungsschalter Sₒ₁, Sₒ₂, Sₒ₃, Sₒ₄, Sᵤ₁, Sᵤ₂, Sᵤ₃, Sᵤ₄ eines, hinlänglich bekannten mehrphasigen DC/DC-Wandlers 1 ansteuert.

Ein grundlegender beispielhafter Aufbau eines Batteriemodells 3 kann beispielsweise aus der AT 510 998 A2 oder der AT 513 676 A2 entnommen werden.

Der DC/DC-Wandler 1 erzeugt die benötige Ausgangsspannung v₂ und stellt sie der Last 5 zur Verfügung. Eingangsseitig wird beispielsweise eine dreiphasige Wechselspannung AC mittels eines Gleichrichters 4 und einem Glättungskondensator Co zu einer Gleichspannung v₀ gleichgerichtet. Der Glättungskondensator Co wird als hinreichend groß angenommen, womit die Dynamik des Gleichrichters 4 vernachlässigt und die Gleichspannung v₀ konstant angenommen werden kann. Die Gleichspannung v₀ versorgt den DC/DC-Wandler 1.

Der DC/DC-Wandler 1 ist in diesem Ausführungsbeispiel als vierstrangiger Synchronwandler, bestehend aus parallelen Halbbrücken HB_{1,} HB₂, HB₃, HB₄ und zugehörigen Drosseln, L1, L2, L3, L4, deren Strangströme i_{L1}, i_{L2}, i_{L3}, i_{L4} jeweils durch das Schaltverhalten der zugehörigen Halbbrücke HB_{1,} HB₂, HB₃, HB₄ angesteuert werden, ausgeführt. Die Halbbrücken HB_{1,} HB₂, HB₃, HB₄ bestehen aus jeweils einem oberen Leistungsschalter Sₒ₁, Sₒ₂, Sₒ₃, Sₒ₄ und jeweils einem unteren Leistungsschalter Sᵤ₁, Sᵤ₂, Sᵤ₃, Sᵤ₄ und gegebenenfalls zugehörigen Freilaufdioden Dₒ₁, Dᵤ₁, Dₒ₂, Dᵤ₂, Dₒ₃, Dᵤ₃, Dₒ₄, Dᵤ₄. Pro Strang ist somit je eine Halbbrücken HB_{1,} HB₂, HB₃, HB₄ und eine Drossel L₁, L₂, L₃, L₄ vorgesehen, wobei die Drosseln L₁, L₂, L₃, L₄ einerseits zwischen dem oberen Leistungsschaltern Sₒ₁, Sₒ₂, Sₒ₃, Sₒ₄ und unteren Leistungsschaltern Sᵤ₁, Sᵤ₂, Sᵤ₃, Sᵤ₄ mit jeweils einer Halbbrücke HB_{1,} HB₂, HB₃, HB₄ verbunden sind und andererseits ausgangsseitig miteinander verbunden sind. Damit ergibt sich der Ausgangsstrom i₁ als Summe der Strangströme i_{L1}, i_{L2}, i_{L3}, i_{L4}. Ohmsche Widerstände der Drosseln L₁, L₂, L₃, L₄ sind in Fig. 1 der Einfachheit halber nicht dargestellt, können aber auch berücksichtigt werden. Zudem ist üblicherweise ein ausgangsseitiger Glättungskondensator C₂ vorhanden, der gemeinsam mit den Drosseln L₁, L₂, L₃, L₄ und der Ausgangsinduktivität L einen Ausgangsfilter des Synchronwandlers bildet. Dieses Filter erhält den Ausgangsstrom i₁ bzw. eine Zwischenspannung v₁ am Eingang und liefert weiter eine Ausgangsspannung v₂ und damit einen Laststrom i_{L}. Der DC/DC-Wandler 1 kann selbstverständlich auch in einer anderen Ausführung, z.B. mit weniger oder mehr Strängen, etc. ausgeführt sein.

Die Leistungsschalter Sₒ₁, Sₒ₂, Sₒ₃, Sₒ₄, Sᵤ₁, Sᵤ₂, Sᵤ₃, Sᵤ₄ der Halbbrücken werden durch eine Steuereinheit 2 angesteuert, um die gewünschte Ausgangsspannung v₂, die den benötigten Laststrom i_{L} ergibt, einzustellen. Die oberen Leistungsschalter Sₒ₁, Sₒ₂, Sₒ₃, Sₒ₄ und die jeweils zugehörigen unteren Leistungsschalter Sᵤ₁, Sᵤ₂, Sᵤ₃, Sᵤ₄ einer Halbbrücke HB_{1,} HB₂, HB₃, HB₄ werden grundlegend alternierend geschaltet, um einen Kurzschluss zu verhindern. Die grundlegende Steuerung von Halbbrücken HB_{1,} HB₂, HB₃, HB₄ eines Synchronwandlers zum Erzeugen des Laststroms i_{L} kann als bekannt vorausgesetzt werden.

Üblicherweise ist im Stand der Technik in der Steuereinheit 2 eine ebenso hinlänglich bekannte Pulsweitenmodulation (PWM) vorgesehen, um über das Tastverhältnis der Leistungsschalter Sₒ₁, Sₒ₂, Sₒ₃, Sₒ₄, Sᵤ₁, Sᵤ₂, Sᵤ₃, Sᵤ₄ die Ausgangsspannung v₂ bzw. den gewünschten Laststrom i_{L} über die Strangströme i_{L1}, i_{L2}, i_{L3}, i_{L4} einzustellen. Da eine PWM bei jedem Abtastschritt schaltet, begrenzt diese Limitierung auch die Abtastrate und somit auch die Reglerbandbreite. Diese Beschränkung führt zu einer eingeschränkten Dynamik der Regelung solcher DC/DC-Wandler 1, d.h. dass oftmals nicht schnell genug auf Störungen oder transiente Schaltvorgänge der Last 5 reagiert werden kann.

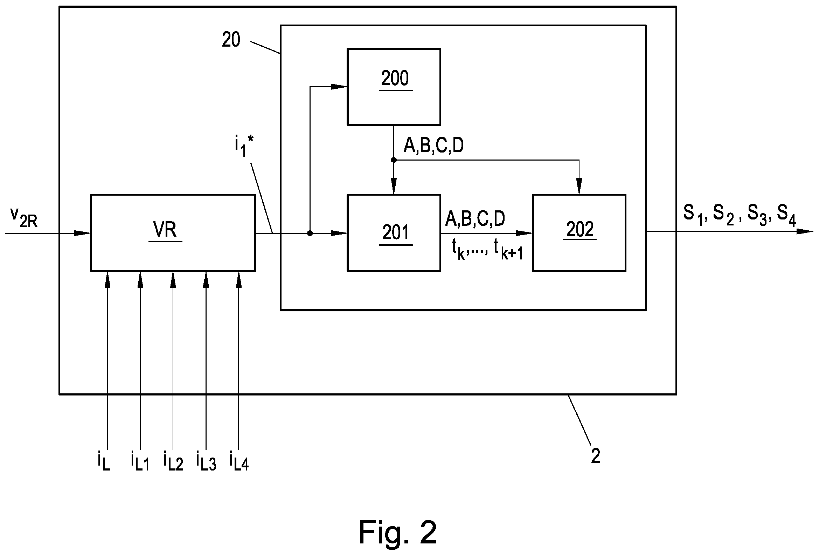

Aus diesem Grund steuert die Steuereinheit 2 die Leistungsschalter Sₒ₁, Sₒ₂, Sₒ₃, Sₒ₄, Sᵤ₁, Sᵤ₂, Sᵤ₃, Sᵤ₄ nicht auf Basis einer PWM an, sondern erfindungsgemäß mittels einer Predictive Pulse Pattern Control (PPPC). Die Steuereinheit 2 erhält weiterhin die Strangströme i_{L1}, i_{L2}, i_{L3}, i_{L4} (die gemessen werden können), sowie den aktuellen Laststrom i_{L} (der gemessen werden kann), und die aktuelle Ausgangsspannung v₂ (die gemessen werden kann) als Eingangsgröße. Um nun ein schnelleres und genaueres Einstellen der Ausgangsspannung v₂ zu erreichen, wird auf der Steuereinheit 2 eine Kombination aus einer inneren und äußeren Regelschleife, wie in Fig. 2 dargestellt, verwendet.

Die äußere Regelschleife weist einen Spannungsregler VR auf, welcher einer durch eine PPPC-Einheit 20 gebildeten inneren Regelschleife überlagert ist. Der Spannungsregler VR erhält von Batteriemodell 3 die Referenzspannung v_{2R}, sowie weitere elektrischen Größen der Batterieemulators (z.B. die Strangströme i_{L1}, i_{L2}, i_{L3}, i_{L4}, die Ausgangsspannung v₂, den Laststrom i_{L}, etc. und regelt darauf basierend einen Strom i₁*. Hierfür kann grundsätzlich jeder beliebige geeignete Regler implementiert werden. Eine mögliche Regelungsstrategie für den Spannungsregler VR ist ein modellprädiktiver Regler (MPC), der den Fehler zwischen den tatsächlichen Ausgangsstrom i₁ (der z.B. gemessen wird) und dem vom Spannungsregler VR eingestellten Strom i₁^{*} über den Prädiktionshorizont N_{P} minimiert. Dazu kann in der MPC zusätzlich noch eine systembedingte Begrenzung des Ausgangsstrom i₁ berücksichtigt werden. Die für den Spannungsregler VR benötigten Größen werden entweder gemessen und/oder anhand eines Beobachters, z.B. in Form eines Kalman Filters, aus messbaren Größen (insbesondere i₁, i₂, v₁, v₂, i_{L1}, i_{L2}, i_{L3}, i_{L4}) geschätzt (beispielsweise der Laststrom i_{L}).

Die PPPC-Einheit 20 wiederum besteht aus einem PPPC-Regler 201, einem Pulsgenerator 202 und einer Selektionseinheit 200. Der Pulsgenerator 202 steuert die Leistungsschalter Sₒ₁, Sₒ₂, Sₒ₃, Sₒ₄, Sᵤ₁, Sᵤ₂, Sᵤ₃, Sᵤ₄ durch Schaltpulse S₁, S₂, S₃, S₄ an, um die gewünschten Strangströme i_{L1}, i_{L2}, i_{L3}, i_{L4} und damit den gewünschten Laststrom i_{L}, bzw. die gewünschte Ausgangsspannung v₂ einzustellen. Dabei stehen dem Pulsgenerator 202 diverse, von der Selektionseinheit 200 zur Verfügung gestellte, vordefinierte Pulsmuster A, B, C, D zur Verfügung.

Der PPPC-Regler 20 verarbeitet den vom Spannungsregler VR vorgegebenen Strom i₁* und wählt ein passendes von der Selektionseinheit 200 zur Verfügung gestelltes Pulsmuster A, B, C, D, sowie passende Schaltzeiten t₁, t₂, t₃, t₄, t₅, t₆, t₇, tₖ₊₁ der Pulsmuster A, B, C, D, womit der Pulsgenerator 202 die Leistungsschalter Sₒ₁, Sₒ₂, Sₒ₃, Sₒ₄, Sᵤ₁, Sᵤ₂, Sᵤ₃, Sᵤ₄ über Schaltpulse S₁, S₂, S₃, S₄ entsprechend dieser Pulsmuster A, B, C, D mit entsprechenden Schaltzeiten t₁, t₂, t₃, t₄, t₅, t₆, t₇, tₖ₊₁ ansteuert.

Jedes Pulsmuster A, B, C, D erzeugt die Schaltpulse S₁, S₂, S₃, S₄ jeder Halbbrücke HB_{1,} HB₂, HB₃, HB₄ eine Folge von Schaltpulsen S₁, S₂, S₃, S₄, womit idealerweise der gesamte mögliche Bereich der Ausgangsspannung v₂ abgedeckt wird. Es werden damit zwischen zwei Zeitpunkten tₖ, tₖ₊₁, die vorzugsweise einer Abtastperiode T_{P} entsprechen, pro Phase zwei Schaltaktionen, d.h. zwei Wechsel von aktiv auf inaktiv, der jeweiligen Leistungsschalter Sₒ₁, Sₒ₂, Sₒ₃, Sₒ₄, Sᵤ₁, Sᵤ₂, Sᵤ₃, Sᵤ₄ ermöglicht, wobei die Schaltaktionen zu den frei wählbaren Schaltzeiten tₖ, t₁, t₂, t₃, t₄, t₅, t₆, t₇, tₖ₊₁ stattfinden. Die Anzahl der Schaltzeiten ist dabei natürlich wählbar. Damit wird wie üblich der benötigte Ausgangsstrom i₁ als Summe der Strangströme i_{L1}, i_{L2}, i_{L3}, i_{L4} erzeugt. Durch die Verwendung eines Pulsgenerators 202 können die Schaltpulse S₁, S₂, S₃, S₄ einerseits frei entsprechend den vorgegebenen Pulsmustern A, B, C, D A gewählt werden, wobei weiters frei über die Schaltzeiten tₖ, t₁, t₂, t₃, t₄, t₅, t₆, t₇, tₖ₊₁ verfügt werden kann. Damit ergibt sich eine Unabhängigkeit von einer festen Abtastrate, womit eine hohe Dynamik und Flexibilität gegeben ist.

In der vorliegenden Ausgestaltung werden auf der Selektionseinheit 200 vier Pulsmuster A, B, C, D definiert. Die Pulsmuster A, B, C, D weisen pro Schaltperiode [tₖ, tₖ₊₁], d.h. hier beispielsweise pro Prädiktionsintervall T_{P}, je eine bestimmte Anzahl an Schaltvorgängen, bzw. Wechsel von aktiven Phasen auf inaktive Phasen oder umgekehrt, auf. Das bedeutet, dass in einer Schaltperiode [tₖ, tₖ₊₁] jeder Schaltpuls S₁, S₂, S₃, S₄ nur einmal von aktiv auf inaktiv und von inaktiv auf aktiv schaltet. Damit werden die Leistungsschalter Sₒ₁, Sₒ₂, Sₒ₃, Sₒ₄, Sᵤ₁, Sᵤ₂, Sᵤ₃, Sᵤ₄ der Halbbrücken HB_{1,} HB₂, HB₃, HB₄ über die Schaltpulse S₁, S₂, S₃, S₄ in einer Weise gesteuert, dass unterschiedliche Strangströme i_{L1}, i_{L2}, i_{L3}, i_{L4} in den Drosseln L₁, L₂, L₃, L₄ erzeugt werden. Diese Strangströme i_{L1}, i_{L2}, i_{L3}, i_{L4} ergeben, wie erwähnt in Summe den Ausgangsstrom i₁, womit in weiterer Folge eine Ausgangsspannung v₂ und ein Laststrom i_{L} erzeugt werden.

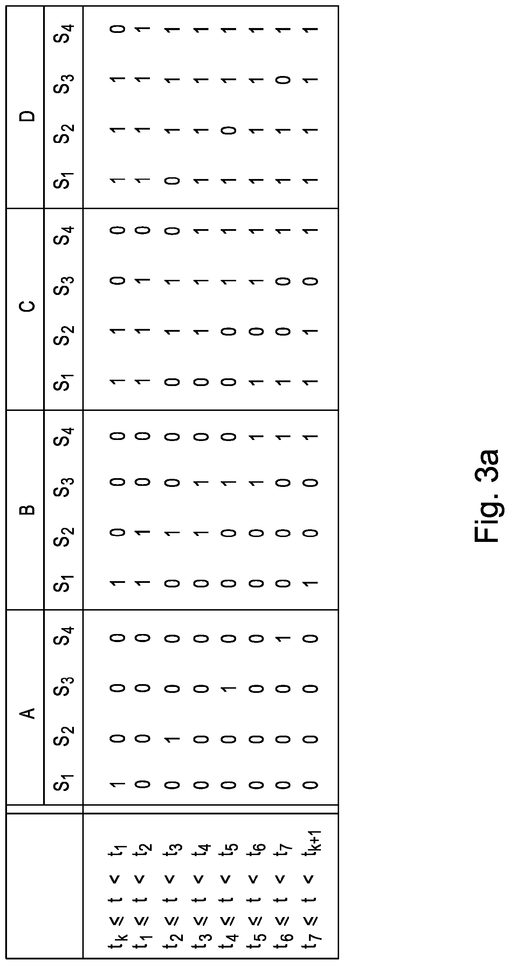

Fig. 3a zeigt eine beispielhafte Auswahl an vier Pulsmustern A, B, C, D. Das Pulsmuster A weist Schaltpulse S₁, S₂, S₃, S₄ in der Art auf, sodass zum selben Zeitpunkt in keinem oder maximal in einem Strang eine aktive Phase auftritt. Das Pulsmuster B weist Schaltpulse S₁, S₂, S₃, S₄ mit einem oder zwei Strängen mit gleichzeitig aktiven Phasen auf, das Pulsmuster C Schaltpulse S₁, S₂, S₃, S₄ mit zwei oder drei Strängen mit aktive Phasen und das Pulsmuster D Schaltpulse S₁, S₂, S₃, S₄ mit drei oder vier Strängen mit aktive Phasen auf. Diese Pulsmuster A, B, C, D der Schaltsignale S₁, S₂, S₃, S₄, mit denen die Leistungsschalter Sₒ₁, Sₒ₂, Sₒ₃, Sₒ₄, Sᵤ₁, Sᵤ₂, Sᵤ₃, Sᵤ₄ angesteuert werden, sind in Fig. 3a tabellarisch dargestellt. Daraus ergibt sich eine potentielle Auswahl an Ausgangsströmen i₁ die beim nächsten Abtastzeitpunkt tₖ₊₁ erreicht werden können. Die Pulsmuster A, B, C, D ermöglichen je nach Anzahl der gleichzeitig aktiven Phasen unterschiedliche Ausgangsströme i₁. So kann mittels des Pulsmusters D natürlich potentiell ein größerer Ausgangsstrom i₁, als mit dem Pulsmuster A erreicht werden. Es wird somit vom PPPC-Regler 201 abgeschätzt, welches dieser von der Selektionseinheit 200 zur Verfügung gestellten Pulsmuster A, B, C, D mit welchen Schaltzeiten tₖ, t₁, t₂, t₃, t₄, t₅, t₆, t₇, tₖ₊₁ gewählt werden muss, um zum nächsten Abtastzeitpunkt tₖ₊₁ die Abweichung des erzeugten Stroms i₁ vom Spannungsregler VR vorgegebenen Strom i₁^{*} zu minimieren.

So kann beispielsweise erst allgemein ein Pulsmuster A, B, C, D gewählt werden, das den erzeugten Ausgangsstrom i₁ an den vom Spannungsregler VR vorgegebenen Stroms i₁^{*} annähert, d.h. dessen möglicher Wertebereich (der durch die unterschiedlichen möglichen Schaltzeiten tₖ, t₁, t₂, t₃, t₄, t₅, t₆, t₇, tₖ₊₁ vorgegeben ist) den vorgegebenen Stroms i₁^{*} beinhaltet. Zusätzlich hat man in den Schaltzeiten tₖ, t₁, t₂, t₃, t₄, t₅, t₆, t₇, tₖ₊₁ einen zusätzlichen Freiheitsgrad, um den Ausgangsstrom i₁ zum Zeitpunkt tₖ₊₁ einzustellen. Zur Ermittlung der Schaltzeiten tₖ, t₁, t₂, t₃, t₄, t₅, t₆, t₇, tₖ₊₁ für das ausgewählte Pulsmuster A, B, C, D kann ein Optimierungsproblem aufgestellt werden, um die optimalen Schaltzeiten tₖ, t₁, t₂, t₃, t₄, t₅, t₆, t₇, tₖ₊₁ für den vorgegebenen Ausgangsstrom i₁^{*} zu ermitteln. Erfindungsgemäß wird eine Kostenfunktion J_{K} als Funktion der j Schaltzeiten und der Ausgangsstrom i₁, und gegebenenfalls weiterer Größen, angesetzt, also J_{K}=f(tⱼ, i₁^{*}, ...). Diese Kostenfunktion J_{K} bewertet die Abweichung der vergebenen Ausgangsstromes i₁^{*} und des erzeugten Ausgangsstromes i₁ und wird hinsichtlich der Schaltzeiten t₁, t₂, t₃, t₄, t₅, t₆, t₇ (tₖ, tₖ₊₁ vorgegeben und nicht änderbar) optimiert, in der Regel minimiert, also t = argmin|ₜ J_{K}, mit dem Schaltzeitvektor **t**, der die j Schaltzeiten enthält. Hierzu kann ein geeignetes Abbruchkriterium bestimmt werden, beispielsweise das unterschreiten einer Abweichungsschwelle oder eine Anzahl von Iterationen. Damit erhält man eine optimale Annäherung des vorgegebenen Ausgangsstromes i₁^{*} durch das Pulsmuster A, B, C, D.

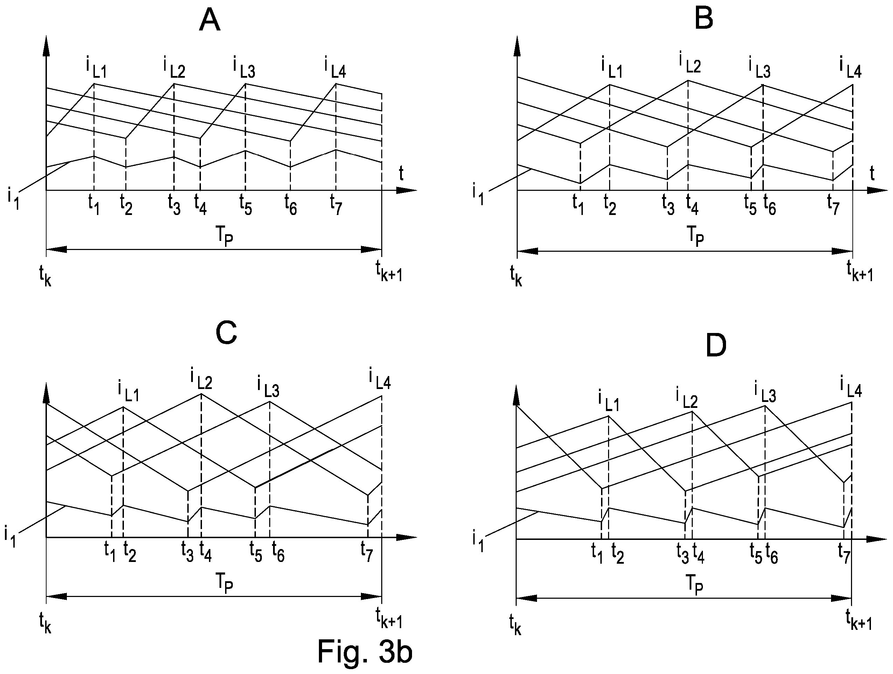

Fig. 3b zeigt auf Basis der Pulsmuster A, B, C, D und Schaltzeiten tₖ, t₁, t₂, t₃, t₄, t₅, t₆, t₇, tₖ₊₁ abgeschätzte Strangsströme i_{L1}, i_{L2}, i_{L3}, i_{L4}, sowie den jeweils daraus resultierenden abgeschätzten Ausgangsstrom i₁. Zu erkennen sind die unterschiedlichen Schaltzeiten t₁, t₂, t₃, t₄, t₅, t₆, t₇.

Durch die Wahl der Pulsmuster A, B, C, D und der zugehörige Schaltzeiten t₁, t₂, t₃, t₄, t₅, t₆, t₇, tₖ₊₁ können am PPPC-Regler im Gegensatz zu einer üblichen FCS-MPC die erwarteten Werte der Strangströme i_{L1}, i_{L2}, i_{L3}, i_{L4} mit variablen, von der Abtastrate unabhängigen, Schaltzeiten t₁, t₂, t₃, t₄, t₅, t₆, t₇ abgeschätzt werden. Auf Basis dieser Abschätzung können jene Schaltsignale S₁, S₂, S₃, S₄ generiert werden, die einen erwarteten Fehler minimieren, womit eine höhere Genauigkeit und Dynamik erzielt werden kann.

## Patentansprüche

1. Energiespeicheremulator bestehend aus einem eine Anzahl Leistungsschalter (Sₒ₁, Sₒ₂, Sₒ₃, Sₒ₄, Sᵤ₁, Sᵤ₂, Sᵤ₃, Sᵤ₄) umfassenden DC/DC-Wandler (1), der eingerichtet ist, eine Ausgangsspannung (v₂) und einem ausgangsseitigen Laststrom (i_{L}) zur Verfügung zu stellen, einer Steuerungseinheit (2), die ausgestaltet ist aus elektrischen Größen (i_{L1}, i_{L2}, i_{L3}, i_{L} v₂, i_{L}) des DC-DC/Wandlers einen Referenzstrom (i_{2R}) zu berechnen und einem Batteriemodell (3), das mit der Steuerungseinheit (2) verbunden ist und ausgestaltet ist den Referenzstrom (i_{2R}) zu beziehen, zu verarbeiten und daraus eine Referenzspannung (v_{2R}) zu berechnen und der Steuerungseinheit (2) zur Verfügung zu stellen, wobei in der Steuerungseinheit (2) ein Spannungsregler (VR) vorgesehen ist, der die Referenzspannung (v_{2R}) verarbeitet und einen einzustellenden Strom (i₁*) regelt, auf dessen Basis die Steuerungseinheit (2) die Leistungsschalter (Sₒ₁, Sₒ₂, Sₒ₃, Sₒ₄, Sᵤ₁, Sᵤ₂, Sᵤ₃, Sᵤ₄) über Schaltpulse (S₁, S₂, S₃, S₄) ansteuert um die Ausgangspannung (v₂) zu regeln, **dadurch gekennzeichnet dass** eine Predictive Pulse-Pattern-Control-Einheit (20) vorhanden ist, die mit dem Spannungsregler (VR) verbunden ist und einen Predictive-Pulse-Pattern-Control-Regler (201), einen Pulsgenerator (202) und eine Selektionseinheit (200), die eine Anzahl an Pulsmustern (A, B, C, D) zur Verfügung stellt, umfasst, **dass** der Predictive-Pulse-Pattern-Control-Regler (201) ausgestaltet ist auf Basis des vom Spannungsregler (VR) einzustellenden Stroms (i₁*) ein Pulsmuster (A, B, C, D) der Selektionseinheit (200) auszuwählen, und die Leistungsschalter (Sₒ₁, Sₒ₂, Sₒ₃, Sₒ₄, Sᵤ₁, Sᵤ₂, Sᵤ₃, Sᵤ₄) über den Pulsgenerator (202) mittels Schaltpulsen (S₁, S₂, S₃, S₄) nach diesem Pulsmuster (A, B, C, D) anzusteuern, um die Ausgangsspannung (v₂) zu regeln, **und dass** die Predictive-Pulse-Pattern-Control-Einheit (20) ausgestaltet ist, auf Basis des einzustellenden Stromes (i₁*) die Schaltzeiten (t₁, t₂, t₃, t₄, t₅, t₆, t₇) des ausgewählten Pulsmusters (A, B, C, D) der Leistungsschalter (Sₒ₁, Sₒ₂, Sₒ₃, Sₒ₄, Sᵤ₁, Sᵤ₂, Sᵤ₃, Sᵤ₄) festzulegen, wobei die Predictive-Pulse-Pattern-Control-Einheit (20) ausgestaltet ist, zur Festlegung der Schaltzeiten (t₁, t₂, t₃, t₄, t₅, t₆, t₇) eine Kostenfunktion (J_{K}) als Funktion der Schaltzeiten (t₁, t₂, t₃, t₄, t₅, t₆, t₇) und eines Ausgangsstromes (i₁) anzusetzen, wobei die Kostenfunktion (J_{K}) die Abweichung des einzustellenden Stromes (i₁^{*}) und des Ausgangsstromes (i₁) bewertet, und die Kostenfunktion (J_{K}) hinsichtlich der Schaltzeiten (t₁, t₂, t₃, t₄, t₅, t₆, t₇) zu optimieren.

2. Verfahren zur Emulation eines Energiespeichers, wobei eine Ausgangsspannung (v₂) eines DC/DC-Wandlers (1) geregelt wird, indem eine Steuerungseinheit (2) aus elektrischen Größen (i_{L1}, i_{L2}, i_{L3}, i_{L4}, i_{L}, v₂) des DC-DC/Wandlers (1) einen Referenzstrom (i_{2R}) berechnet und an ein Batteriemodell (3) liefert, wobei das Batteriemodell (2) den Referenzstrom (i_{2R}) verarbeitet, daraus die Referenzspannung (v_{2R}) berechnet und an den Spannungsregler (VR) übergibt, welcher die Referenzspannung (v_{2R}) verarbeitet und einen einzustellenden Strom (i₁*) regelt, auf dessen Basis die Steuerungseinheit (2) die Leistungsschalter (Sₒ₁, Sₒ₂, Sₒ₃, Sₒ₄, Sᵤ₁, Sᵤ₂, Sᵤ₃, Sᵤ₄) mittels Schaltpulsen (S₁, S₂, S₃, S₄) ansteuert, um die Ausgangspannung (v₂) zu regeln **dadurch gekennzeichnet dass** eine Predictive-Pulse-Pattern-Control-Einheit (20) auf Basis des vom Spannungsregler (VR) einzustellenden Stroms (i₁*) ein Pulsmuster (A, B, C, D) aus einer Anzahl vorgegebener Pulsmuster (A, B, C, D) auswählt, und die Leistungsschalter (Sₒ₁, Sₒ₂, Sₒ₃, Sₒ₄, Sᵤ₁, Sᵤ₂, Sᵤ₃, Sᵤ₄) des DC/DC-Wandlers (1) nach dem ausgewählten Pulsmuster (A, B, C, D) ansteuert um die Ausgangsspannung (v₂) zu regeln, **und dass** die Predictive-Pulse-Pattern-Control-Einheit (20) auf Basis des einzustellenden Stromes (i₁*) die Schaltzeiten (t₁, t₂, t₃, t₄, t₅, t₆, t₇) des ausgewählten Pulsmusters (A, B, C, D) der Leistungsschalter (Sₒ₁, Sₒ₂, Sₒ₃, Sₒ₄, Sᵤ₁, Sᵤ₂, Sᵤ₃, Sᵤ₄) festlegt, wobei zur Festlegung der Schaltzeiten (t₁, t₂, t₃, t₄, t₅, t₆, t₇) eine Kostenfunktion (J_{K}) als Funktion der Schaltzeiten (t₁, t₂, t₃, t₄, t₅, t₆, t₇) und eines Ausgangsstromes (i₁) angesetzt wird, wobei die Kostenfunktion (J_{K}) die Abweichung des einzustellenden Stromes (i₁^{*}) und des Ausgangsstromes (i₁) bewertet, und wobei die Kostenfunktion (J_{K}) hinsichtlich der Schaltzeiten (t₁, t₂, t₃, t₄, t₅, t₆, t₇) optimiert wird.

## Claims

1. Energy accumulator emulator consisting of a DC-to-DC converter (1), having a number of power switches (Sₒ₁, Sₒ₂, Sₒ₃, Sₒ₄, Sᵤ₁, Sᵤ₂, Sᵤ₃, Sᵤ₄), the DC-to-DC converter (1) being configured to provide an output voltage (v₂) and an output-side load current (i_{L}), a control unit (2), which is designed to calculate a reference current (i_{2R}) from electrical variables (i_{L1}, i_{L2}, i_{L3}, i_{L} v₂, i_{L}) of the DC-to-DC converter and a battery model (3), which is connected to the control unit (2) and is configured to obtain and process the reference current (i_{2R}) and to calculate a reference voltage (v_{2R}) from it and to provide it to the control unit (2), wherein the control unit (2) contains a voltage controller (VR), which processes the reference voltage (v_{2R}) and controls a current (i₁*) to be set, on the basis of which the control unit (2) controls the power switches (Sₒ₁, Sₒ₂, Sₒ₃, Sₒ₄, Sᵤ₁, Sᵤ₂, Sᵤ₃, Sᵤ₄) via switching pulses (S₁, S₂, S₃, S₄) in order to control the output voltage (v₂), **characterized in that** a Predictive Pulse-Pattern-Control unit (20) is provided, which is connected to the voltage controller (VR) and comprises a Predictive Pulse-Pattern-Control controller (201), a pulse generator (202) and a selection unit (200), which provides a number of pulse patterns (A, B, C, D), **that** the Predictive Pulse-Pattern-Control controller (201) is configured to select a pulse pattern (A, B, C, D) of the selection unit (200) on the basis of the current (i₁*) to be set by the voltage controller (VR) and to control the power switches (Sₒ₁, Sₒ₂, Sₒ₃, Sₒ₄, Sᵤ₁, Sᵤ₂, Sᵤ₃, Sᵤ₄) via the pulse generator (202) by means of switching pulses (S₁, S₂, S₃, S₄) according to this pulse pattern (A, B, C, D) in order to control the output voltage (v₂), **and that** the Predictive Pulse-Pattern-Control unit (20) is configured to select the switching times (t₁, t₂, t₃, t₄, t₅, t₆, t₇) of the selected pulse pattern (A, B, C, D) of the power switches (Sₒ₁, Sₒ₂, Sₒ₃, Sₒ₄, Sᵤ₁, Sᵤ₂, Sᵤ₃, Sᵤ₄) on the basis of the current (i₁*) to be set, wherein the Predictive Pulse-Pattern-Control unit (20) in order to select the switching times (t₁, t₂, t₃, t₄, t₅, t₆, t₇) is configured to apply a cost function (J_{K}) as a function of the switching times (t₁, t₂, t₃, t₄, t₅, t₆, t₇) and an output current (i₁), which cost function (J_{K}) evaluates the deviation of the current (i₁^{*}) to be set and the output current (i₁), and to optimize the cost function (J_{K}) with regard to the switching times (t₁, t₂, t₃, t₄, t₅, t₆, t₇).

2. Method for the emulation of an energy accumulator device, wherein an output voltage (v₂) of a DC-to-DC converter (1) is controlled by means of a control unit (2) which calculates a reference current (i_{2R}) from electrical variables (i_{L1}, i_{L2}, i_{L3}, i_{L4}, i_{L}, v₂) of the DC-to-DC converter (1) and provides it to a battery model (3), wherein the battery model (3) processes the reference current (i_{2R}), calculates the reference voltage (v_{2R}) from it and transmits it to the voltage controller (VR), which processes the reference voltage (v_{2R}) and controls a current (i₁*) to be set, on the basis of which the control unit (2) controls the power switches (Sₒ₁, Sₒ₂, Sₒ₃, Sₒ₄, Sᵤ₁, Sᵤ₂, Sᵤ₃, Sᵤ₄) via switching pulses (S₁, S₂, S₃, S₄) to control the output voltage (v₂), **characterized in that** a Predictive Pulse-Pattern-Control unit (20) selects a pulse pattern (A, B, C, D) from a number of predefined pulse patterns (A, B, C, D) on the basis of the current (i₁*) to be set by the voltage controller (VR), and controls the power switches (Sₒ₁, Sₒ₂, Sₒ₃, Sₒ₄, Sᵤ₁, Sᵤ₂, Sᵤ₃, Sᵤ₄) of the DC-to-DC converter (1) according to the selected pulse pattern (A, B, C, D) to control the output voltage (v₂), **and that** the Predictive Pulse-Pattern-Control unit (20) selects the switching times (t₁, t₂, t₃, t₄, t₅, t₆, t₇) of the selected pulse pattern (A, B, C, D) of the power switches (Sₒ₁, Sₒ₂, Sₒ₃, Sₒ₄, Sᵤ₁, Sᵤ₂, Sᵤ₃, Sᵤ₄) on the basis of the current (i₁*) to be set, wherein in order to select the switching times (t₁, t₂, t₃, t₄, t₅, t₆, t₇) a cost function (J_{K}) as a function of the switching times (t₁, t₂, t₃, t₄, t₅, t₆, t₇) and an output current (i₁) is applied, which cost function (J_{K}) evaluates the deviation of the current (i₁^{*}) to be set and of the output current (i₁), and wherein the cost function (J_{K}) is optimized with regard to the switching times (t₁, t₂, t₃, t₄, t₅, t₆, t₇).

## Revendications

1. Émulateur d'accumulateur d'énergie constitué d'un convertisseur CCICC (1) comprenant un certain nombre de disjoncteurs de puissance (Sₒ₁, Sₒ₂, Sₒ₃, Sₒ₄, Sᵤ₁, Sᵤ₂, Sᵤ₃, Sᵤ₄) et configuré pour fournir une tension de sortie (v₂) et un courant de charge (L) côté sortie, d'une unité de commande (2) configurée pour calculer un courant de référence (i_{2R}) à partir de grandeurs électriques (i_{L1}, i_{L2}, i_{L3}, i_{L} v₂, i_{L}) du convertisseur CC/CC et d'un modèle de batterie (3) connecté à l'unité de commande (2) et configuré pour acquérir et traiter le courant de référence (i_{2R}) et pour calculer une tension de référence (v_{2R}) à partir de celui-ci et la fournir à l'unité de commande (2), dans lequel un régulateur de tension (VR) est prévu dans l'unité de commande (2), lequel traite la tension de référence (v_{2R}) et régule un courant à régler (i₁*), sur la base duquel l'unité de commande (2) commande les disjoncteurs de puissance (Sₒ₁, Sₒ₂, Sₒ₃, Sₒ₄, Sᵤ₁, Sᵤ₂, Sᵤ₃, Sᵤ₄) par l'intermédiaire d'impulsions de commutation (S₁, S₂, S₃, S₄) afin de réguler la tension de sortie (v₂), **caractérisé en ce qu'**une unité de commande prédictive de motifs d'impulsions (20) est prévue, laquelle est connectée au régulateur de tension (VR) et comprend un régulateur de commande prédictive de motifs d'impulsions (201), un générateur d'impulsions (202) et une unité de sélection (200), laquelle fournit un certain nombre de motifs d'impulsions (A, B, C, D), **en ce que** le régulateur de commande prédictive de motifs d'impulsions (201) est configuré pour sélectionner un motif d'impulsions (A, B, C, D) de l'unité de sélection (200) sur la base du courant à régler (i₁*) par le régulateur de tension (VR) et pour commander les disjoncteurs de puissance (Sₒ₁, Sₒ₂, Sₒ₃, Sₒ₄, Sᵤ₁, Sᵤ₂, Sᵤ₃, Sᵤ₄) par l'intermédiaire du générateur d'impulsions (202) au moyen d'impulsions de commutation (S₁, S₂, S₃, S₄) suivant ledit motif d'impulsions (A, B, C, D) afin de réguler la tension de sortie (v₂), **et en ce que** l'unité de commande prédictive de motifs d'impulsions (20) est configurée pour définir les temps de commutation (t₁, t₂, t₃, t₄, t₅, t₆, t₇) du motif d'impulsions (A, B, C, D) sélectionné des disjoncteurs de puissance (Sₒ₁, Sₒ₂, Sₒ₃, Sₒ₄, Sᵤ₁, Sᵤ₂, Sᵤ₃, Sᵤ₄) sur la base du courant à régler (i₁*), dans lequel l'unité de commande prédictive de motifs d'impulsions (20) est configurée pour établir une fonction de coût (J_{K}) en fonction des temps de commutation (t₁, t₂, t₃, t₄, t₅, t₆, t₇) et d'un courant de sortie (i₁) pour la définition des temps de commutation (t₁, t₂, t₃, t₄, t₅, t₆, t₇), dans lequel la fonction de coût (J_{K}) évalue l'écart entre le courant à régler (i₁*) et le courant de sortie (ii), et pour optimiser la fonction de coût (J_{K}) en ce qui concerne les temps de commutation (t₁, t₂, t₃, t₄, t₅, t₆, t₇).

2. Procédé permettant l'émulation d'un accumulateur d'énergie, dans lequel une tension de sortie (v₂) d'un convertisseur CCICC (1) est régulée par le fait qu'une unité de commande (2) calcule un courant de référence (i_{2R}) à partir de grandeurs électriques (i_{L1}, i_{L2}, i_{L3}, i_{L4}, i_{L}, v₂) du convertisseur CC/CC (1) et le délivre à un modèle de batterie (3), dans lequel le modèle de batterie (2) traite le courant de référence (i_{2R}), calcule la tension de référence (v_{2R}) à partir de celui-ci et la transmet au régulateur de tension (VR), lequel traite la tension de référence (v_{2R}) et régule un courant à régler (i₁*), sur la base duquel l'unité de commande (2) commande les disjoncteurs de puissance (Sₒ₁, Sₒ₂, Sₒ₃, Sₒ₄, Sᵤ₁, Sᵤ₂, Sᵤ₃, Sᵤ₄) au moyen d'impulsions de commutation (S₁, S₂, S₃, S₄) afin de réguler la tension de sortie (v₂), **caractérisé en ce qu'**une unité de commande prédictive de motifs d'impulsions (20) sélectionne un motif d'impulsions (A, B, C, D) à partir d'un certain nombre de motifs d'impulsions (A, B, C, D) prédéfinis sur la base du courant à régler (i₁*) par le régulateur de tension (VR) et commande les disjoncteurs de puissance (Sₒ₁, Sₒ₂, Sₒ₃, Sₒ₄, Sᵤ₁, Sᵤ₂, Sᵤ₃, Sᵤ₄) du convertisseur CCICC (1) suivant le motif d'impulsions (A, B, C, D) sélectionné afin de réguler la tension de sortie (v₂), **et en ce que** l'unité de commande prédictive de motifs d'impulsions (20) définit les temps de commutation (t₁, t₂, t₃, t₄, t₅, t₆, t₇) du motif d'impulsions (A, B, C, D) sélectionné des disjoncteurs de puissance (Sₒ₁, Sₒ₂, Sₒ₃, Sₒ₄, Sᵤ₁, Sᵤ₂, Sᵤ₃, Sᵤ₄) sur la base du courant à régler (i₁*), dans lequel une fonction de coût (J_{K}) est établie en fonction des temps de commutation (t₁, t₂, t₃, t₄, t₅, t₆, t₇) et d'un courant de sortie (ii) pour la définition des temps de commutation (t₁, t₂, t₃, t₄, t₅, t₆, t₇), dans lequel la fonction de coût (J_{K}) évalue l'écart entre le courant à régler (i₁*) et le courant de sortie (i₁), et dans lequel la fonction de coût (J_{K}) est optimisée en ce qui concerne les temps de commutation (t1, t₂, t₃, t₄, t₅, te, t₇).
